(19) **Europäisches Patentamt**

**European Patent Office**

**Office européen des brevets**

(11) **EP 1 710 914 A1**

(12) **EUROPEAN PATENT APPLICATION**

(43) Date of publication:
**11.10.2006 Bulletin 2006/41**

(51) Int Cl.:
**H03K 19/003** (2006.01)

(21) Application number: **05254322.0**

(22) Date of filing: **11.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.03.2005 JP 2005073680**

(71) Applicant: **FUJITSU LIMITED**
**Kawasaki-shi,**
**Kanagawa 211-8588 (JP)**

(72) Inventor: **Sakabayashi, Sota,**
**c/o Fujitsu Limited**
**Kawasaki-shi,**
**Kanagawa 211-8588 (JP)**

(74) Representative: **Gibbs, Christopher Stephen**
**HASELTINE LAKE**
**Imperial House,**
**15-19 Kingsway**
**London WC2B 6UD (GB)**

(54) **Input protection circuit**

(57) To provide an input protection circuit capable of controlling the validity/invalidity of pull-up/pull-down without degradation in characteristic, the input protection circuit includes an input protection resistor (4) connected between an external input terminal (2) and a buffer circuit (3) connected to an internal circuit, a p-type MOS transistor (5) one terminal of which is connected to a power source and the other to a point between the external input terminal (2) and the input protection resistor (4), and an input protection resistor (6).

F I G. 7

**Description**

**Background of the Invention**

**Field of the Invention**

The present invention relates to an input protection circuit, and more specifically to an input protection circuit capable of controlling the validity/invalidity of pull-up/pull-down.

**Description of the Related Art**

Generally, an input protection resistor is input between an internal circuit such as an integrated circuit, etc. and an external input terminal (input pad) to protect the internal circuit (internal transistor, etc.) against static electricity. When an external input terminal enters an open state, pull-up resistor/pull-down resistor is inserted to keep a high level state/low level state, and protect an internal circuit from a malfunction due to the influence of noise, etc.

Japanese Published Patent Application No. Hei 03-079120 discloses an input protection circuit (Figs. 3 and 4 of Japanese Published Patent Application No. Hei 03-079120) having an input protection resistor inserted between an external input terminal and an internal circuit, and a pull-up or pull-down resistor one terminal of which is connected to a predetermined power source and the other terminal is connected between the input protection resistor and the internal circuit, and an input protection circuit (Figs. 1 and 2 of Japanese Published Patent Application No. Hei 03-079120) having an input protection resistor inserted between an external input terminal and an internal circuit, and a pull-up or pull-down resistor one terminal of which is connected to a predetermined power source and the other terminal is connected between the external input terminal and the input protection resistor.

The above-mentioned pull-up resistor/pull-down resistor is used in various types of usage, and can be requested to have the function of nullifying the pull-up/pull-down as necessary.

For example, assume that a leakage test is performed for quality assurance. For example, when it is checked whether or not there occurs a physical short circuit between the external input terminals of a data bus, it is necessary to nullify the pull-up/pull-down provided for the input unit of the internal circuit, apply a voltage between external input terminals, and measure the leakage current.

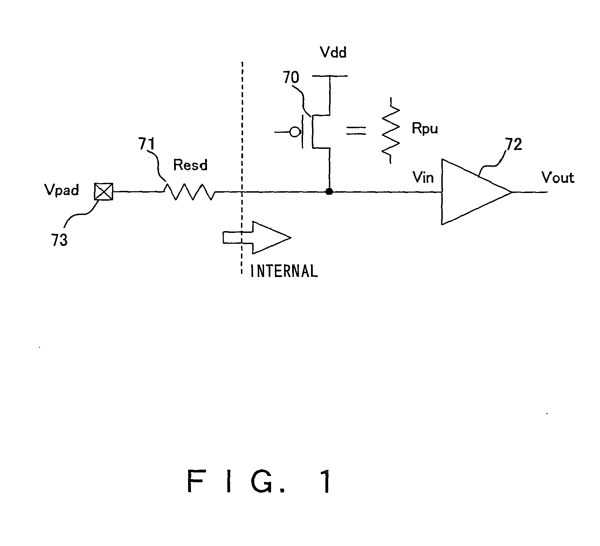

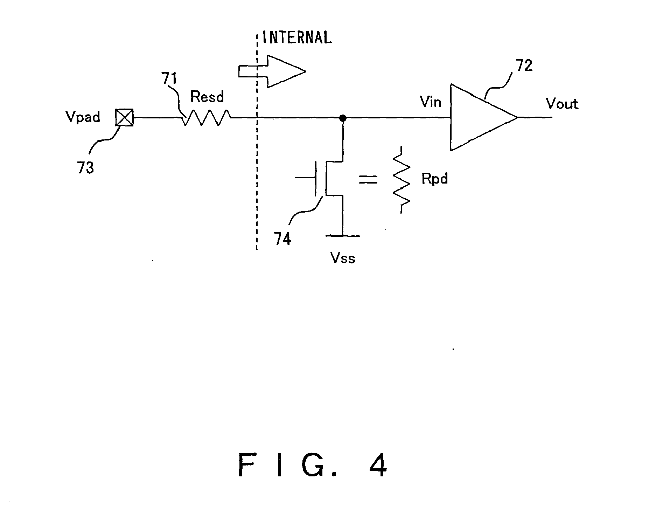

In this case, for example, the circuit shown in Figs. 1 and 4 can be assumed.

Fig. 1 shows a circuit in which a pull-up resistor Rpu is configured by a p-type MOS transistor 70, one terminal is connected to a power source Vdd and the other terminal is connected between an input protection resistor 71 and a buffer circuit (internal circuit) 72. Similarly, Fig. 4 shows a circuit in which a pull-up resistor Rpd is configured by an n-type MOS transistor 74, one terminal is connected to a power source Vss and the other terminal is connected between an input protection resistor 71 and a buffer circuit 72.

In Fig. 1, when the MOS transistor 70 enters an ON state, the input impedance of the buffer circuit 72 is high. Therefore, a direct current flows from the power source Vdd to an external input terminal (input pad) 73. At this time, the following equation holds where the resistor between the source and drain is represented by Rpu, the resistance value of the input protection resistor 71 is represented by Resd, the voltage generated by the input protection resistor 71 is represented by Vshift_pu, the voltage of the external input terminal 73 is represented by Vpad, and the input voltage to the buffer circuit 72 is represented by Vin when the MOS transistor 70 enters the ON state.

$$\mathtt{Vshift\_pu = (Vdd - Vpad) \ x \ Resd \ / \ (Rpu + Resd)}$$

$$\mathtt{Vin \qquad = Vpad + Vshift\_pu}$$

Therefore, when the threshold voltage viewed from the external input terminal 73 is shifted by the voltage Vshift_pu generated by the input protection resistor 71, and the threshold voltage of the buffer circuit 72 is represented by Vth, the following equation holds.

$$\mathtt{Vpad = Vth - Vshift\_pu}$$

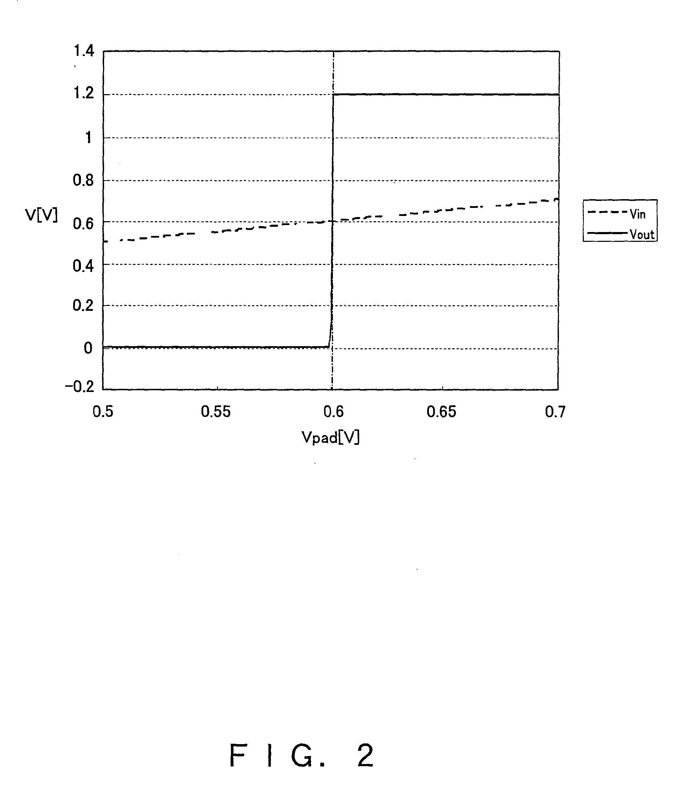

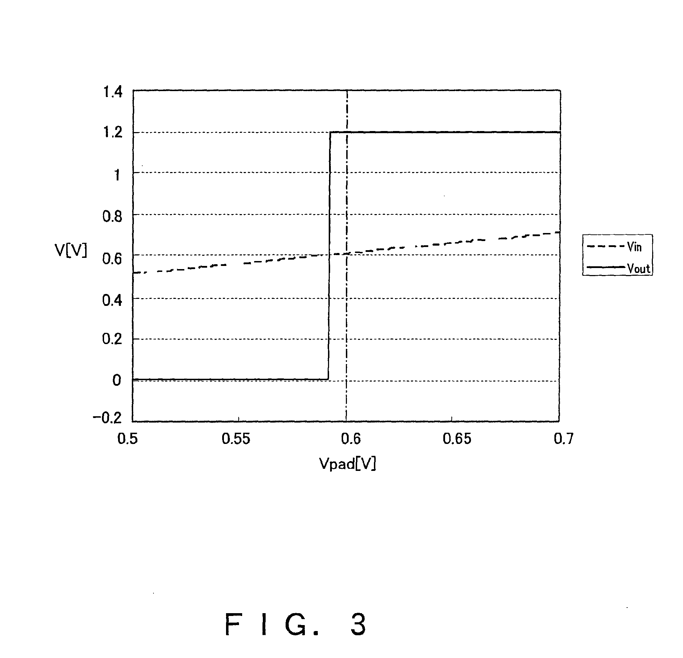

Fig. 2 shows the relationship between the input voltage Vin and the output voltage Vout of the buffer circuit 72 shown in Fig. 1 when the MOS transistor 70 enters an OFF state. Fig. 3 shows the relationship between the input voltage Vin and the output voltage Vout of the buffer circuit 72 shown in Fig. 1 when the MOS transistor 70 enters the ON state.

In Fig. 2, while the threshold voltage viewed from the external input terminal 73 is about 0.6 V, the threshold voltage shown in Fig. 3 is shifted by about 0.01 V (Vshift_pu).

Likewise, in Fig. 4, when the MOS transistor 74 enters the ON state, the following equation holds where the resistance between the drain and source is represented by Rpd, and the voltage generated by the input protection resistor 71 is represented by Vshift_pd.

$$Vshift\_pd = (Vpad - Vss) \times Resd / (Rpd + Resd)$$

$$Vin \qquad = Vpad - Vshift\_pd$$

Therefore, when the threshold voltage viewed from the external input terminal 73 is shifted by the voltage Vshift_pd generated by the input protection resistor 71, and the threshold voltage of the buffer circuit 72 is represented by Vth, the following equation holds.

$$Vpad = Vth + Vshift\_pd$$

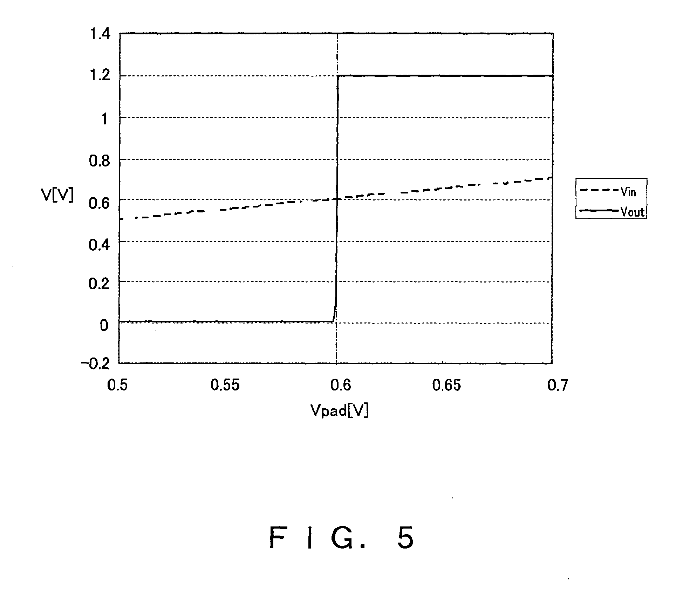

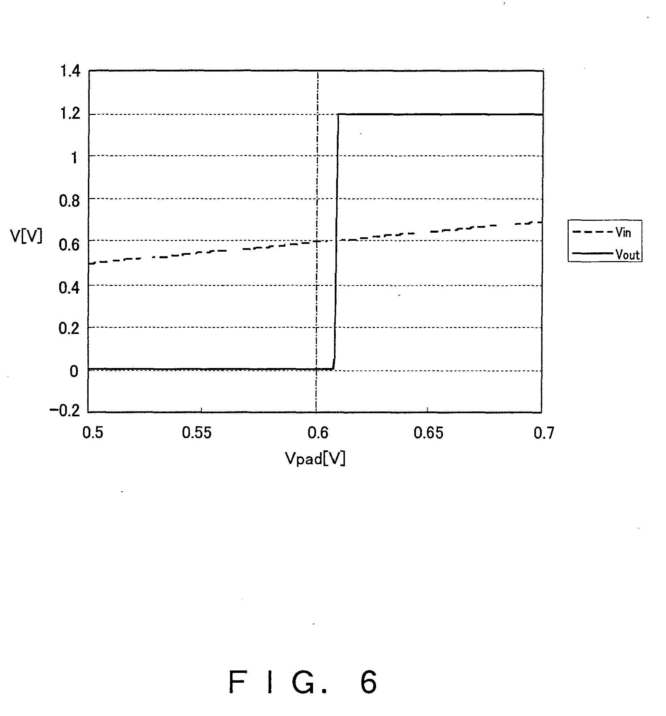

Fig. 5 shows the relationship between the input voltage Vin and the output voltage Vout of the buffer circuit 72 shown in Fig. 4 when the MOS transistor 74 enters an OFF state. Fig. 6 shows the relationship between the input voltage Vin and the output voltage Vout of the buffer circuit 72 shown in Fig. 4 when the MOS transistor 74 enters the ON state.

In Fig. 5, while the threshold voltage viewed from the external input terminal 73 is about 0.6 V, the threshold voltage shown in Fig. 6 is shifted by about 0.01 V (Vshift_pu).

As described above, when the threshold voltage viewed from the external input terminal 73 fluctuates, it causes the problem of degradation in characteristic to the input signal that the duty ratio of an input clock signal also fluctuates.

Furthermore, it is also possible to use a MOS transistor as the pull-up resistor/pull-down resistor between the external input terminal and the input protection resistor of the input protection circuit disclosed in Japanese Published Patent Application No. Hei 03-079120 shown in Figs. 1 and 2, but it causes the problem in ESD by connecting an internal transistor directly to an external terminal.

**Summary of the Invention**

The present invention has been developed to solve the above-mentioned problems, and aims at providing an input protection circuit capable of controlling the validity/invalidity of the pull-up/pull-down without degradation in characteristic.

To solve the above-mentioned problems, the input protection circuit according to the present invention includes: a first input protection unit which is connected between an external input/output terminal and an internal circuit, and protects the internal circuit against an overvoltage input to the external input/output terminal; and a pull-up unit which is connected between a predetermined voltage source and a point between the external input/output terminal and the first input protection unit., holds a predetermined voltage when the external input/output terminal opens, and has a switch unit for switching validity/invalidity of the pull-up unit.

According to the present invention, the pull-up unit can switch the validity/invalidity of the pull-up unit using a switch unit. Therefore, for example, the pull-up unit can be switched between validity and invalidity as necessary at a leakage test, etc.

Furthermore, since the pull-up unit is connected between a predetermined voltage source and a point between the external input terminal and the first input protection unit, the degradation in characteristic that the threshold voltage of the buffer circuit connected to the internal circuit depends on the validity/invalidity of the pull-up unit (shift) can be prevented.

Additionally, the input protection circuit according to the present invention has a similar effect by including: a first input protection unit which is connected between an external input/output terminal and an internal circuit, and protects the internal circuit against an overvoltage input to the external input/output terminal; and a pull-down unit which is connected between a predetermined voltage source and a point between the external input/output terminal and the first input protection unit, holds a predetermined voltage when the external input/output terminal opens, and has a switch unit for switching validity/invalidity of the pull-down unit.

As described above, the present invention can provide an input protection circuit capable of controlling the validity/invalidity of pull-up/pull-down without degradation in characteristic.

## Brief Description of the Drawings

Fig. 1 shows an example of a circuit in which a pull-up resistor is configured by a p-type MOS transistor, one terminal is connected to a power source and the other terminal is connected between an input protection resistor and an internal circuit;

Fig. 2 shows the relationship between an input voltage and an output voltage of a buffer circuit shown in Fig. 1 when a MOS transistor enters an OFF state;

Fig. 3 shows the relationship between an input voltage and an output voltage of a buffer circuit shown in Fig. 1 when a MOS transistor enters an ON state;

Fig. 4 shows an example of a circuit in which a pull-down resistor is configured by an n-type MOS transistor, one terminal is connected to a power source and the other terminal is connected between an input protection resistor and an internal circuit;

Fig. 5 shows the relationship between an input voltage and an output voltage of a buffer circuit shown in Fig. 4 when a MOS transistor enters an OFF state;

Fig. 6 shows the relationship between an input voltage and an output voltage of a buffer circuit shown in Fig. 4 when a MOS transistor enters an ON state;

Fig. 7 shows an example of the configuration of an input protection circuit capable of controlling the validity/invalidity of pull-up according to the present embodiment;

Fig. 8 shows an example of the configuration of an input protection circuit capable of controlling the validity/invalidity of pull-down according to the present embodiment;

Fig. 9 shows the relationship between an input voltage and an output voltage of a circuit shown in Fig. 7 when a MOS transistor enters an OFF state;

Fig. 10 shows the relationship between an input voltage and an output voltage of a circuit shown in Fig. 7 when a MOS transistor enters an ON state;

Fig. 11 shows the relationship between an input voltage and an output voltage of a circuit shown in Fig. 8 when a MOS transistor enters an OFF state; and

Fig. 12 shows the relationship between an input voltage and an output voltage of a circuit shown in Fig. 8 when a MOS transistor enters an ON state.

## Description of the Preferred Embodiments

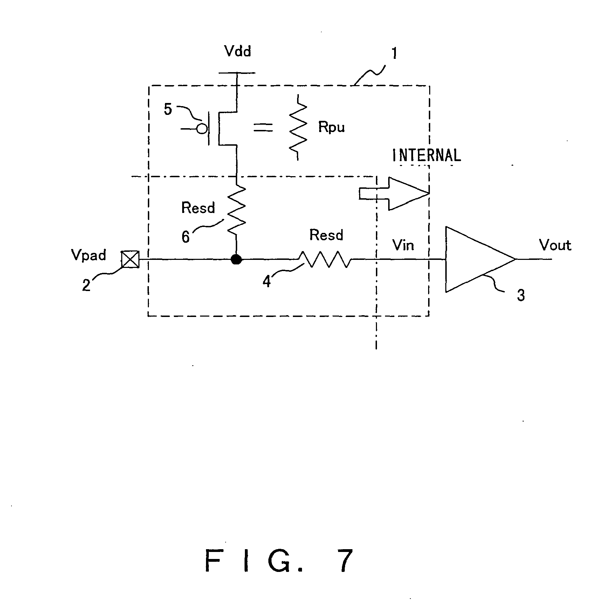

The embodiment of the present invention is explained below by referring to Figs. 7 through 12.

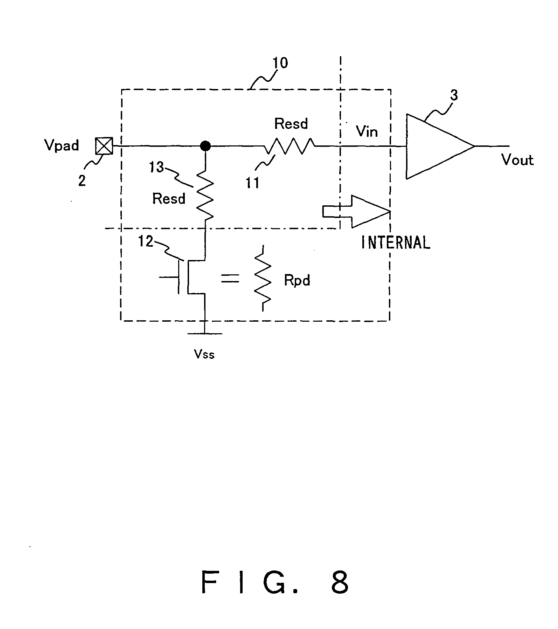

Figs. 7 and 8 show examples of the configurations of the input protection circuit according to the embodiments of the present invention.

Fig. 7 shows an example of the configuration of the input protection circuit capable of controlling the validity/ invalidity of pull-up according to the present invention.

An input protection circuit 1 according to the present embodiment shown in Fig. 7 comprises: an input protection resistor 4 (first input protection unit) connected between an external input terminal (input pad) 2 and a buffer circuit 3 connected to an internal circuit; and a pull-up unit comprising a p-type MOS transistor (switch unit) 5 one terminal of which is connected to a power source Vdd and the other terminal is connected between the external input terminal 2 and the input protection resistor 4 and an input protection resistor (second input protection unit) 6.

The MOS transistor 5 is connected in series with the input protection resistor 6.

With the above-mentioned configuration, the input protection resistor 4 protects an internal transistor connected after the buffer circuit 3 against the overvoltage of the discharge, etc. of static electricity. The input protection resistor 6 connected in series with the MOS transistor 5 protects the MOS transistor 5 against the overvoltage of the discharge, etc. of static electricity.

Therefore, the internal circuit (MOS transistor 5, and internal transistors connected after the buffer circuit 3) can be protected against the degradation or destruction by the stress of the discharge of static electricity.

The MOS transistor 5 controls such that the resistor between the source and the drain functions as a pull-up resistor in the ON state, and the pull-up can be nullifies in the OFF state.

Therefore, for example, it is possible to control the validity/invalidity of pull-up as necessary during the leakage test. As a result, since a physical short circuit between the external input terminals can be detected, uneven products can be easily selected during production, thereby improving the quality of the products.

Furthermore, since one terminal of the MOS transistor 5 connected in series with the input protection resistor 6 is connected between the external input terminal 2 and the input protection resistor 4, no direct current flows through the input protection resistor 4 from the power source although the pull-up is effective, thereby having the effect of suppressing a DC path in which a threshold voltage shifts.

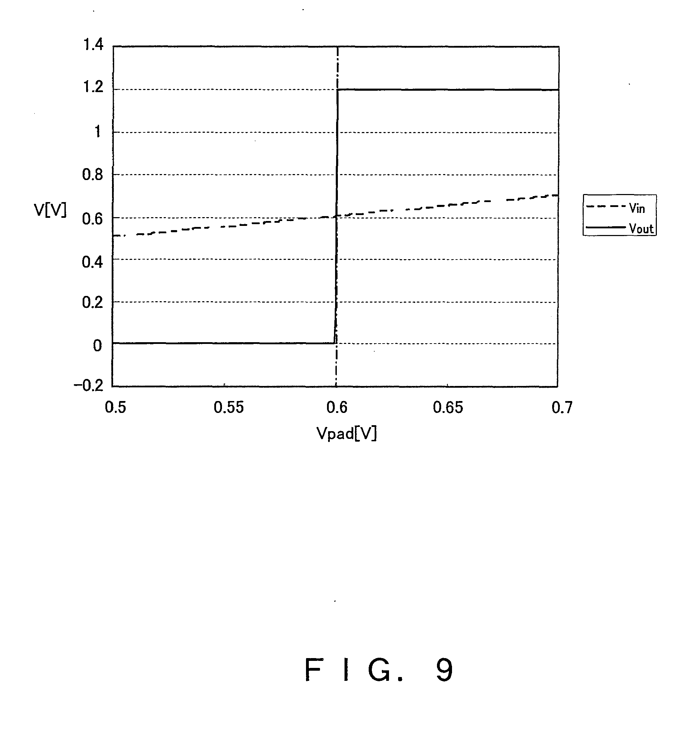

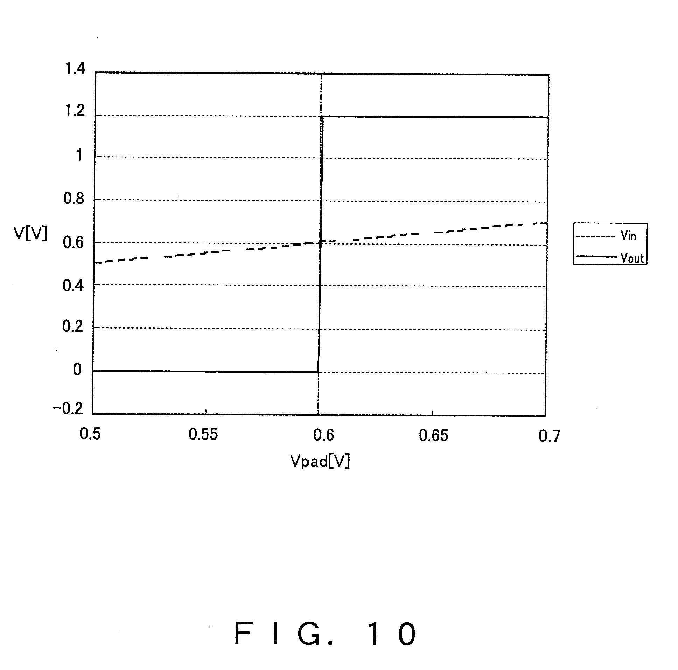

Fig. 9 shows the relationship between the input voltage and the output voltage of the buffer circuit 3 shown in Fig. 7 when the MOS transistor 5 enters the OFF state. Fig. 10 shows the relationship between the input voltage and the output voltage of the buffer circuit 3 shown in Fig. 7 when the MOS transistor 5 enters the ON state.

The threshold voltage viewed from the external input terminal 2 shown in Fig. 9 and the threshold voltage shown in Fig. 10 are 0.6 V, and there occurs no shift in threshold voltage.

Fig. 8 shows an example of the configuration of an input protection circuit capable of controlling the validity/invalidity of pull-down according to the present embodiment.

An input protection circuit 10 according to the present embodiment shown in Fig. 8 comprises: an input protection resistor 11 (first input protection unit) connected between an external input terminal (input pad) 2 and a buffer circuit 3 connected to an internal circuit; and a pull-down unit comprising an n-type MOS transistor (switch unit) 12 one terminal of which is connected to the ground (Vss) and the other terminal is connected between the external input terminal 2 and the input protection resistor 11 and an input protection resistor (second input protection unit) 13.

The MOS transistor 12 is connected in series with the input protection resistor 13.

The configuration above is, as shown in Fig. 7, the input protection resistor 11 protects the internal transistor connected after the buffer circuit 3 against the overvoltage of the discharge, etc. of static electricity, and the input protection resistor 13 protects the MOS transistor 12 against the overvoltage of the discharge, etc. of static electricity.

Therefore, the internal circuit (MOS transistor 12, and internal transistors connected after the buffer circuit 3) can be protected against the degradation or destruction by the stress of the discharge of static electricity.

The MOS transistor 12 controls such that the resistor between the source and the drain functions as a pull-down resistor in the ON state, and the pull-down can be nullifies in the OFF state.

Therefore, for example, it is possible to control the validity/invalidity of pull-down as necessary during the leakage test. As a result, since a physical short circuit between the external input terminals can be detected, uneven products can be easily selected during production, thereby improving the quality of the products.

Furthermore, since one terminal of the MOS transistor 12 connected in series with the input protection resistor 13 is connected between the external input terminal 2 and the input protection resistor 11 and, although the pull-up is effective, thereby having the effect of suppressing a DC path in which a threshold voltage shifts.

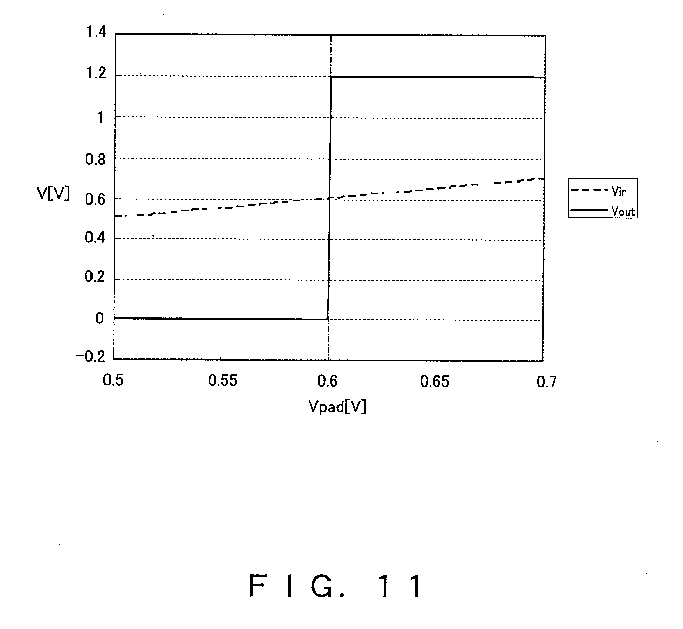

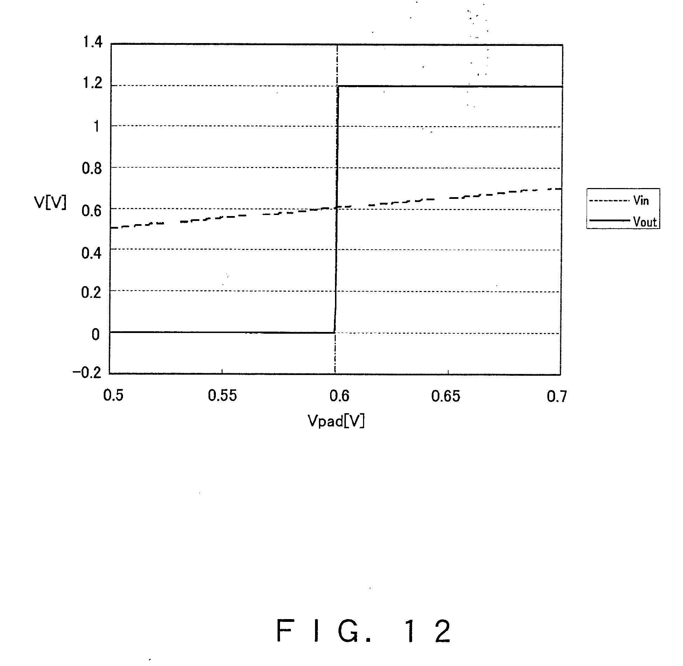

Fig. 11 shows the relationship between the input voltage and the output voltage of the buffer circuit 3 shown in Fig. 8 when the MOS transistor 12 enters the OFF state. Fig. 12 shows the relationship between the input voltage and the output voltage of the buffer circuit 3 shown in Fig. 8 when the MOS transistor 12 enters the ON state.

The threshold voltage viewed from the external input terminal 2 shown in Fig. 11 and the threshold voltage shown in Fig. 12 are 0.6 V, and there occurs no shift in threshold voltage.

In Figs. 7 and 8, the MOS transistors 5 and 12 are included in an internal circuit (internal transistor), but the present invention is not limited to these applications, and it is not always necessary to include the MOS transistors 5 and 12 in an internal circuit to obtain the effect of the present invention.

Figs. 7 and 8 show the case in which the input protection circuit 1 or 10 is used for the external input terminal 2, but the present invention is not limited to this application. That is, when the input protection circuit 1 or 10 according to the present embodiment is used for an external input terminal with the similar effect.

**Claims**

**1.** An input protection circuit, comprising:

   a first input protection unit (4), which is connected between an external input/output terminal and an internal circuit, and protects the internal circuit against an overvoltage input to the external input/output terminal; and
   a pull-up unit which is connected between a predetermined voltage source and a point between the external input/output terminal and the first input protection unit (4), holds a predetermined voltage when the external input/output terminal opens, and has a switch unit (5) for switching validity/invalidity of the pull-up unit.

**2.** A circuit according to claim 1, wherein the pull-up unit is connected to a point between the external input/output terminal and the first input protection unit (4), and the switch unit (5), and further comprises a second input protection unit (6) for protecting the switch unit (5) against an overvoltage input to the external input/output terminal.

**3.** An input protection circuit, comprising:

a first input protection unit (11), which is connected between an external input/output terminal and an internal circuit, and protects the internal circuit against an overvoltage input to the external input/output terminal; and a pull-down unit, which is connected between a predetermined voltage source and a point between the external input/output terminal and the first input protection unit (11), holds a predetermined voltage when the external input/output terminal opens, and has a switch unit (12) for switching validity/invalidity of the pull-down unit.

**4.** A circuit according to claim 3, wherein the pull-down unit is connected to a point between the external input/output terminal and the first input protection unit (11), and the switch unit (12), and further comprises a second input protection unit (13) for protecting the switch unit (12) against an overvoltage input to the external input/output terminal.

**5.** The circuit according to claim 2 or 4, wherein the first and second input protection units (4, 6; 11,13) are input protection resistors constituted by passive resistor elements.

**6.** A circuit according to claim 5, wherein the switch unit (5; 12) is configured by an active element.

**7.** A circuit according to claim 6, wherein the switch unit (5; 12) is constituted by a MOS transistor.

**8.** An input protection circuit, comprising:

first input protection means (4), which is connected between an external input/output terminal and an internal circuit, and protects the internal circuit against an overvoltage input to the external input/output terminal; and pull-up means, which is connected between a predetermined voltage source and a point between the external input/output terminal and the first input protection means (4), holds a predetermined voltage when the external input/output terminal opens, and has switch means (5) for switching validity/invalidity of the pull-up means.

**9.** An input protection circuit, comprising:

first input protection means (11), which is connected between an external input/output terminal and an internal circuit, and protects the internal circuit against an overvoltage input to the external input/output terminal; and pull-down means, which is connected between a predetermined voltage source and a point between the external input/output terminal and the first input protection means (11), holds a predetermined voltage when the external input/output terminal opens, and has switch means (12) for switching validity/invalidity of the pull-down means.

**10.** A method for protecting an internal circuit, comprising:

connecting a first input protection means (4; 11) protecting the internal circuit against an overvoltage input to an external input/output terminal between the external input/output terminal and the internal circuit; and connecting a pull-up or pull-down means which holds a predetermined voltage when the external input/output terminal is open, and has a switch means (5; 12) switching validity/invalidity of the pull-up or pull-down means, between a predetermined voltage source and a point between the external input/output terminal and the first input protection means (4; 11).

Vdd

70

Rpu

71

Resd

Vpad

73

Vin

72

Vout

INTERNAL

F I G. 1

F I G. 2

F I G. 3

INTERNAL

71

Resd

Vpad

73

72

Vin

Vout

Rpd

74

Vss

F I G. 4

F I G. 5

F I G. 6

# F I G. 7

F I G. 8

F I G. 9

F I G. 1 0

F I G. 1 1

F I G. 1 2

**European Patent Office**

**EUROPEAN SEARCH REPORT**

Application Number

EP 05 25 4322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 369 997 A (FUJITSU LIMITED) 10 December 2003 (2003-12-10) * paragraphs [0092] - [0098]; figures 21B,22B,23A * | 1-10 | INV. H03K19/003 |
| Y,D | PATENT ABSTRACTS OF JAPAN vol. 015, no. 250 (E-1082), 26 June 1991 (1991-06-26) -& JP 03 079120 A (FUJITSU LTD; others: 01), 4 April 1991 (1991-04-04) * abstract; figures 1,2 * | 1-10 | |
| Y | EP 0 771 072 A (NEC CORPORATION) 2 May 1997 (1997-05-02) * column 2, line 49 - column 3, line 7; figure 7 * | 1-10 | |

TECHNICAL FIELDS SEARCHED (IPC)

H03K
H01L
H02H

The present search report has been drawn up for all claims

| Place of search | Date of completion of the search | Examiner |
|---|---|---|
| Munich | 30 August 2006 | Moll, P |

EPO FORM 1503 03.82 (P04C01)

## ANNEX TO THE EUROPEAN SEARCH REPORT
## ON EUROPEAN PATENT APPLICATION NO.

EP 05 25 4322

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2006

| Patent document cited in search report | | | Publication date | Patent family member(s) | | | Publication date |
|---|---|---|---|---|---|---|---|
| EP 1369997 | A | | 10-12-2003 | CN | 1463077 | A | 24-12-2003 |
| | | | | JP | 2004007212 | A | 08-01-2004 |
| | | | | TW | 583831 | B | 11-04-2004 |
| | | | | US | 2005206324 | A1 | 22-09-2005 |
| | | | | US | 2003222684 | A1 | 04-12-2003 |
| JP 03079120 | A | | 04-04-1991 | NONE | | | |
| EP 0771072 | A | | 02-05-1997 | DE | 69601342 | D1 | 25-02-1999 |
| | | | | DE | 69601342 | T2 | 26-08-1999 |
| | | | | JP | 3415347 | B2 | 09-06-2003 |
| | | | | JP | 9120324 | A | 06-05-1997 |
| | | | | KR | 210557 | B1 | 15-07-1999 |
| | | | | US | 5764075 | A | 09-06-1998 |

EPO FORM P0459

**EP 1 710 914 A1**

**REFERENCES CITED IN THE DESCRIPTION**

**Patent documents cited in the description**

- JP 3079120 A